# FASCICULE DE BREVET EUROPEEN

(11) **EP 1 172 026 B1**
(45) Date de publication et mention de la délivrance du brevet: **31.10.2007**
(21) Numéro de dépôt: 00985334.2
(22) Date de dépôt: 27.11.2000
(51) Int. Cl.: H05K 7/20

(54) **MODULE ELECTRONIQUE DE PUISSANCE ET PROCEDE DE FABRICATION D'UN TEL MODULE**
ELEKTRONISCHES LEISTUNGSMODUL UND HERSTELLUNGSVERFAHREN EINES SOLCHEN MODULS
ELECTRONIC POWER MODULE AND METHOD FOR MAKING SAME

(30) Priorité: 30.11.1999 FR 9915055
(43) Date de publication de la demande: 16.01.2002
(73) Titulaire: Valeo Systèmes de Contrôle Moteur, 95520 Osny (FR)
(72) Inventeur: PLOIX, Olivier, F-62200 Saint Martin Boulogne (FR)
(74) Mandataire: Fruchard, Guy
(86) Numéro de dépôt international: PCT/FR2000/003305
(87) Numéro de publication internationale: WO 2001/041519

(56) Documents cités:
- EP-A- 0 489 958
- EP-A- 0 667 736
- "THIN HEAT PIPE FOR COOLING COMPONENTS ON PRINTED CIRCUIT BOARDS" IBM TECHNICAL DISCLOSURE BULLETIN,US,IBM CORP. NEW YORK, vol. 34, no. 7B, 1 décembre 1991 (1991-12-01), pages 321-322, XP000282594 ISSN: 0018-8689

## Description

La présente invention concerne les modules électroniques comportant un substrat métallique à base d'aluminium portant au moins un composant de puissance, tel qu'un transistor. Un tel module trouve une application particulièrement importante, bien que non exclusive, dans le domaine automobile où on utilise des circuits électroniques qui alimentent des organes du moteur et sont placés dans une ambiance à température élevée, ce qui complique l'évacuation de la chaleur dissipée par le ou les composants.

Un mode d'assemblage connu consiste à monter le transistor (ou tout autre élément dissipant de la chaleur) sur le substrat en aluminium relativement mince (quelques millimètres) par l'intermédiaire d'une couche mince isolante. Cette solution présente des limitations. La couche isolante, dont la surface ne dépasse pas celle du composant, présente une résistance thermique importante. L'inertie thermique du substrat en aluminium est relativement faible et ne permet pas d'absorber des variations rapides de la puissance dissipée par le composant sans variation notable de température.

On connaît également du document EP-A-489958 un module correspondant au préambule de la revendication 1, comportant un composant appliqué directement sur une plaque par un rivet.

La présente invention vise notamment à fournir un module répondant mieux que ceux antérieurement connus aux exigences de la pratique, notamment en ce qu'il réduit la résistance thermique du circuit de dissipation de la chaleur et permet de supporter des pointes rapides de puissance thermique dissipée.

Dans ce but l'invention propose un module comprenant : un substrat métallique à base d'aluminium; au moins une barre constituant liaison équipotentielle en matériau à base de cuivre, fixée au substrat par l'intermédiaire d'une couche isolante; au moins un composant de puissance en contact direct avec la barre ou les barres par une surface inférieure à celle de la couche isolante; et une carte de circuit imprimé montée sur la barre ou les barres et en débordant, portant les composantes à dissipation thermique réduite du module, le module comportant de plus une ou des barres de passage de courant de puissance auxquelles sont reliées des sorties du composant ou des composants de puissance.

Les barres peuvent être maintenues fortement pressées contre le substrat par des rivets ou vis prenant appui sur la carte, elle-même en appui sur les barres, et dont l'extrémité s'engage dans le substrat. Si les vis ou rivets ne sont pas en matériau électriquement isolant, ils sont séparés de la barre ou des barres par des chemises isolantes.

La carte de circuit imprimé portera généralement des pistes conductrices sur les deux faces, ce qui permet d'assurer des liaisons avec la barre ou les barres et permet de monter des composants sur la face tournée vers le substrat là où la carte déborde des barres.

La carte peut comporter des ouvertures de passage de saillies de la barre qui portent un composant de puissance ou un raccordement d'un tel composant, ce qui facilite le montage.

L'invention propose également un mode de fabrication d'un module du genre ci-dessus défini, suivant lequel :
- on soude, sur au moins une barre en matériau métallique à base de cuivre, un ou des composants de puissance,
- on revêt une grande face de la barre ou des barres à l'opposé du composant ou des composants, d'une couche d'un matériau isolant thermo-durcissable,
- on monte une carte de circuit imprimé équipée de composants de dissipation réduite par rapport à celle de composants de puissance sur la ou les barres,
- on serre l'assemblage ainsi constitué sur un substrat métallique à base d'aluminium à l'aide de vis ou de rivets, et
- on réalise les jonctions entre les sorties du composant de puissance et des barres de passage de courant de puissance.

Dans la pratique, on sera généralement amenés à utiliser des barres ayant une section minimale d'environ 10mm2. Le matériau isolant revêtant la grande face des barres peut notamment être d'un type qui, lors d'un premier chauffage, flue en remplissant la porosité des faces entre lesquelles il se trouve.

Les caractéristiques ci-dessus ainsi que d'autres apparaîtront mieux à la lecture de la description qui suit d'un mode particulier de réalisation, donné à titre d'exemple non limitatif. La description se réfère à la figure unique qui l'accompagne et qui est une vue schématique en coupe d'une fraction de module.

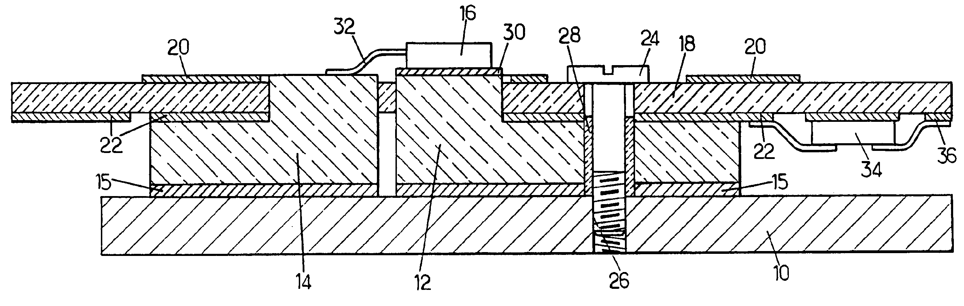

Le module montré en figure 1 comprend un substrat 10 en un matériau métallique à base d'aluminium, qui constituera souvent l'une des parois d'une boîte de circulation d'un fluide qui sert au refroidissement. Ce fluide peut également être un fluide de travail, tel que l'huile d'une électropompe commandée par le module. Sur le substrat 10 sont montées une ou des barres en cuivre par l'intermédiaire d'une couche isolante 15. La figure montre deux barres 12 et 14 placées parallèlement l'une à l'autre. L'une des barres 12 est destinée à recevoir un composant de puissance 16 (ou plusieurs composants de puissance travaillant en parallèle). L'autre barre 14 est destinée à véhiculer des courants de puissance traversant le composant 16. Le module comporte encore une carte de circuit imprimé 18 gravée sur les deux faces pour présenter des plages de contact en cuivre telles que 20 et 22. Dans le mode de réalisation illustré, chaque barre présente une partie en saillie qui s'engage dans une ouverture correspondante de la carte de circuit imprimé 18.

Les connexions électriques éventuellement nécessaires entre les plages de contact 22 de la carte et les barres sont effectuées par pression de la carte contre les barres. Dans le mode de réalisation illustré, les moyens permettant de presser les uns contre les autres la carte 18, les barres 12 et 14 et le substrat 10 comprennent des vis 24. La tête de la vis prend appui sur une partie non métallisée de la carte 18. La tige de chaque vis s'engage dans un trou taraudé 26 du substrat 10. Si la vis 24 est en matériau conducteur, elle sera entourée par une bague isolante 28 à sa traversée de la barre. Au lieu de vis, il est possible d'utiliser des rivets.

Etant donné que chaque barre 12 est séparée du substrat 10 par une couche isolante 15, les composants de puissance peuvent être fixés sur les barres par une soudure conductrice 30, présentant une conductivité thermique très supérieure à celle d'une couche isolante. La conductivité réduite de la couche 15 est compensée par le fait qu'elle présente une surface beaucoup plus importante que celle qu'aurait une couche isolante placée directement sous le composant 16.

Les courants de puissance échangés entre les composants 16 et le reste du module peuvent être transférés par l'intermédiaire de barres 14, sur lesquelles sont soudées les pattes de liaison 32 des composants. Les barres 14 ont une forte section de passage de courant, donc de faibles pertes résistives, et évacuent la chaleur générée dans la barre et dans le composant par un trajet ayant une résistance thermique réduite.

La carte de circuit imprimé peut porter, en plus des composants de puissance, des composants à faible dissipation thermique montés de façon traditionnelle sur la face de la carte éloignée du substrat et/ou sur la face tournée vers le substrat. La figure montre un tel composant 34 fixé sur la face tournée vers le substrat. La figure montre un tel composant 34 fixé sur la face tournée vers le substrat, raccordé à des pistes métallisées classiques 36.

En général, on utilisera un substrat de quelques millimètres d'épaisseur et des barres de cuivre 12 et 14 ayant au moins 10 mm2 de section droite. La carte de circuit imprimée pourra être une carte classique en matière plastique renforcée par des fibres, portant des pistes et des plages de contact en cuivre de quelques dizaines de microns d'épaisseur.

Diverses variantes de réalisation sont possibles . En particulier, il n'est pas indispensable que les barres comportent des saillies traversant la carte de circuit imprimé 18. Le module peut porter plusieurs cartes, dont certaines au moins coopèrent avec des barres.

On décrira maintenant, à titre de simple exemple, un procédé possible de fabrication d'un module suivant l'invention. Certaines des opérations qui vont être décrites peuvent être remplacées par d'autres et l'ordre des opérations peut souvent être interverti.

Les différents sous-ensembles constitutifs du module sont préparés séparément. Les composants tels que 34 ne sont pas destinés à être montés sur des barres sont raccordés et fixés à la carte, par exemple par soudage par fusion. Chaque barre reçoit une couche d'un matériau isolant. On utilisera en général un matériau thermo-durcissable qui sera déposé en couche mince sur la face inférieure de chaque barre, puis polymérisé. Il existe de tels matériaux qui ont l'avantage de fluer légèrement et de remplir la porosité de la face ou des faces vers lesquelles il se trouve lors du chauffage. Une possibilité consiste à effectuer cette polymérisation sur les barres séparées. Les composants de puissance sont fixés sur les barres respectives. On constitue un empilement formé par le substrat, les barres pourvues du matériau isolant et la carte (ou les cartes) équipée et on exerce une pression de contact entre les différents éléments constitutifs à l'aide de vis ou de rivets. Enfin, on effectue les raccordements électriques nécessaires entre les composants de puissance et les barres destinées à véhiculer les courants de puissance.

## Revendications

1. Module comprenant : un substrat métallique (10) à base d'aluminium ; au moins une barre (12) constituant liaison équipotentielle en matériau à base de cuivre, fixée au substrat par l'intermédiaire d'une couche isolante (15); au moins un composant de puissance (16), en contact direct avec la barre sur une surface inférieure à celle de la couche isolante ; et une carte de circuit imprimé (18) montée sur la barre ou les barres et en débordant, portant des composants (34) à dissipation thermique réduite du module
**caractérisé en ce que** le module comporte de plus une ou des barres (14) de passage de courant de puissance auxquelles sont reliées des sortie (32) du composant ou des composants de puissance (16).

2. Module suivant la revendication 1, **caractérisé en ce que** les barres (12, 14) sont maintenues pressées contre le substrat métallique (10) par des rivets ou vis (24) prenant appui sur la carte de circuit imprimé (18), elle-même en appui sur les barres (12,14), et dont l'extrémité s'engage dans le substrat métallique (10).

3. Module suivant la revendication 1 ou 2, **caractérisé en ce que** la carte de circuit imprimé (18) porte des pistes conductrices (20,22) sur les deux faces pour assurer des liaisons avec la barre ou les barres (12,14) et/ou pour monter les composants à dissipation thermique réduite sur la face tournée vers le substrat métalllique (10) là où la carte déborde de la barre ou des barres (12).

4. Module suivant l'une quelconque des revendications précédentes, **caractérisé en ce que** la carte de circuit imprimé (18) comporte des ouvertures de passage de saillies de la barre ou de chaque barre (12,14) qui portent un composant de puissance (16) ou un raccordement d'un tel composant.

5. Procédé de fabrication d'un module suivant l'une quelconque des revendications 1 à 4, suivant lequel :
- on soude, sur au moins une barre en matériau métallique à base de cuivre, un ou des composants de puissance,
- on revêt une grande face de la barre ou des barres, à l'opposé du composant ou des composants, d'une couche d'un matériau isolant thermo durcissable,
- on monte une carte de circuit imprimé équipée de composants de dissipation réduite par rapport à celle de composants de puissance sur la barre ou les barres,
- on serre l'assemblage ainsi constitué sur un substrat métallique à base d'aluminium à l'aide de vis ou de rivets, et
- on réalise les jonctions entre les sorties du composant de puissance et des barres de passage de courant de puissance

## Claims

1. Module comprising: an aluminium-based metal substrate (10); at least one bar (12) made of a copper-based material and constituting an equipotential link, fixed to the substrate via an insulating layer (15); at least one power component (16) in direct contact with the bar over an area smaller than the area of the insulating layer; and a printed circuit board (18) mounted on the bar or bars and overhanging it or them, bearing low-thermal-dissipation components (34) of the module, **characterized in that** the module additionally comprises one or more power-current conducting bars (14) to which the outputs (32) of the power component or components (16) are connected.

2. Module according to Claim 1, **characterized in that** the bars (12, 14) are kept pressed against the metal substrate (10) by rivets or screws (24) bearing against the printed circuit board (18), itself bearing against the bars (12, 14) and the ends of which are engaged in the metal substrate (10).

3. Module according to Claim 1 or 2, **characterized in that** the printed circuit board (18) bears conducting tracks (20, 22) on both sides, so as to make connections with the bar or bars (12, 14) and/or so as to mount the low-thermal-dissipation components on the side facing towards the metal substrate (10) in the region(s) where the board overhangs the bar or bars (12).

4. Module according to any one of the preceding claims, **characterized in that** the printed circuit board (18) has passage openings for projections of the bar or of each bar (12, 14) which bear a power component (16) or a connection of such a component.

5. Method of manufacturing a module according to any one of Claims 1 to 4, whereby:
- one or more power component(s) is or are welded to at least one bar made of a copper-based metallic material,
- a large side of the bar or of the bars, on the opposite side to the component or components, is coated with a layer of thermosetting insulating material,
- a printed circuit board equipped with components the dissipation of which is lower than that of the power components is used on the bar or bars,
- the assembly thus formed is clamped down onto an aluminium-based metal substrate using screws or rivets, and
- the joints between the outputs of the power component and power-current conducting bars are made.

## Patentansprüche

1. Modul, das aufweist: ein metallisches Substrat (10) auf Aluminiumbasis; mindestens einen eine äquipotentiale Verbindung bildender Stab auf Kupferbasis (12), der über eine Isolierschicht (15) am Substrat befestigt ist; mindestens ein Leistungsbauteil (16), das mit dem Stab über eine geringere Fläche als die Isolierschicht in direktem Kontakt steht; und eine gedruckte Leiterplatte (18), die auf den Stab oder die Stäbe montiert ist und darüber vorsteht, die Bauteile (34) mit reduzierter Wärmeableitung des Moduls trägt, **dadurch gekennzeichnet, dass** das Modul außerdem eine oder mehrere Leistungsstrom-Durchgangsstäbe (14) aufweist, mit denen Ausgänge (32) des Leistungsbauteils oder der Leistungsbauteile (16) verbunden sind.

2. Modul nach Anspruch 1, **dadurch gekennzeichnet, dass** die Stäbe (12, 14) durch Niete oder Schrauben (24) gegen das metallische Substrat (10) gepresst gehalten werden, die sich auf der gedruckten Leiterplatte (18) abstützen, die selbst auf den Stäben (12, 14) aufliegt, und deren Ende sich in das metallische Substrat (10) einfügt.

3. Modul nach Anspruch 1 oder 2, **dadurch gekennzeichnet, dass** die gedruckte Leiterplatte (18) Leiterbahnen (20, 22) auf den zwei Seiten trägt, um Verbindungen mit dem Stab oder den Stäben (12, 14) zu gewährleisten und/oder um die Bauteile mit reduzierter Wärmeableitung auf der Seite zu montieren, die zum metallischen Substrat (10) gerichtet ist, dort wo die Platte über den Stab oder die Stäbe (12) übersteht.

4. Modul nach einem der vorhergehenden Ansprüche, **dadurch gekennzeichnet, dass** die gedruckte Leiterplatte (18) Durchgangsöffnungen für Vorsprünge des Stabs oder jedes Stabs (12, 14) aufweist, die ein Leistungsbauteil (16) oder einen Anschluss eines solchen Bauteils tragen.

5. Verfahren zur Herstellung eines Moduls nach einem der Ansprüche 1 bis 4, gemäß dem:
- auf mindestens einen Stab aus metallischem Werkstoff auf Kupferbasis eines oder mehrere Leistungsbauteile geschweißt werden,
- eine große Seite des Stabs oder der Stäbe entgegengesetzt zum Bauteil oder den Bauteilen mit einer Schicht eines wärmehärtbaren Isoliermaterials bedeckt wird,
- eine gedruckte Leiterplatte montiert wird, die mit Bauteilen mit reduzierter Ableitung im Vergleich mit derjenigen der Leistungsbauteile auf dem Stab oder den Stäben ausgestattet ist,
- der so gebildete Zusammenbau mit Hilfe von Schrauben oder Nieten auf ein metallisches Substrat auf Aluminiumbasis geklemmt wird, und
- die Verbindungen zwischen den Ausgängen des Leistungsbauteils und den Leistungsstrom-Durchgangsstäben hergestellt werden.
